Europäisches Patentamt

European Patent Office

Office européen des brevets

(19)

(11) **EP 1 413 909 A1**

(12) **EUROPEAN PATENT APPLICATION**
published in accordance with Art. 158(3) EPC

(43) Date of publication:
**28.04.2004 Bulletin 2004/18**

(51) Int Cl.[7]: **G02B 17/06**, H01L 21/027

(21) Application number: **02738617.6**

(86) International application number:
**PCT/JP2002/005532**

(22) Date of filing: **05.06.2002**

(87) International publication number:
**WO 2003/005097 (16.01.2003 Gazette 2003/03)**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **04.07.2001 JP 2001203046**

(71) Applicant: **Nikon Corporation
Tokyo 100-8331 (JP)**

(72) Inventor: **TAKAHASHI, Tomowaki,
c/o NIKON CORPORATION
Chiyoda-ku, Tokyo 100-8331 (JP)**

(74) Representative:
**Whitlock, Holly Elizabeth Ann et al
R G C Jenkins,
26 Caxton Street
London SW1H 0RJ (GB)**

(54) **PROJECTION OPTICAL SYSTEM AND EXPOSURE DEVICE HAVING THE PROJECTION OPTICAL SYSTEM**

(57) A projection optical system having six reflecting mirrors for projecting a reduced image of a first surface on a second surface comprises a first catoptric imaging optical system to form an intermediate image of the first surface and a second catoptric imaging optical system to form an image of the intermediate image on the second surface. The first catoptric imaging optical system includes a pair of convex reflecting mirrors arranged to be opposed to each other.

## FIG. 3

**Description**

<u>TECHNICAL FIELD</u>

The present invention relates to a projection optical system and an exposure apparatus equipped with the projection optical system. Specifically, the present invention relates, for example, to a catoptric projection optical system suitable for use in an X-ray projection exposure apparatus for transferring a circuit pattern on a mask onto a photosensitive substrate by means of a mirror projection method using X-rays.

<u>BACKGROUND ART</u>

Conventionally, in an exposure apparatus for use in production of semiconductor devices or the like, a circuit pattern formed on a mask (or reticle) is projected and transferred onto a photosensitive substrate such as a wafer via a projection optical system. The photosensitive substrate is coated with a resist, and the resist receives light through projection exposure via the projection optical system so that a resist pattern corresponding to a mask pattern is obtained.
The resolution W of an exposure apparatus depends on the wavelength $\lambda$ of exposure light and the numerical aperture NA of the projection optical system. The resolution W is represented by the following formula (a).

$$W = k \cdot \lambda / NA \ (k: constant) \tag{a}$$

Therefore, if improvement in the resolution of an exposure apparatus is to be attained, it is necessary to reduce the wavelength $\lambda$ of the exposure light or to increase the numerical aperture NA of the projection optical system. Generally, it is difficult to increase the numerical aperture of the projection optical system to more than a certain value from the view point of optical design. Therefore, reduction of the wavelength of the exposure light will be required in the future. For example, in the case that KrF excimer laser having a wavelength of 248nm is used as exposure light, a resolution of 0.25μm will be obtained, while in the case that ArF excimer laser having a wavelength of 193nm is used, a resolution of 0.18μm will be obtained. In the case that an X-ray having a smaller wavelength, for example 13nm, is used as exposure light, a resolution smaller than 0.1μm will be obtained.
On the other hand, when X-rays are used as exposure light, since there is no usable transmissive optical material and no usable refractive optical material for X-rays, a reflective or catoptric projection optical system should be used together with a reflective mask. Thus, there have been proposed various catoptric optical systems applicable to exposure apparatus that use X-rays as exposure light, as disclosed for example in Japanese Patent Application Laid-Open No. 61-47914, U.S. Patent No. 5,815,310, Japanese Patent Application Laid-Open No. 9-211322, U.S. Patent No. 5,686,728, Japanese Patent Application Laid-Open No. 10-90602 and WO99/57606.
The prior art catoptric system disclosed in Japanese Patent Application Laid-Open 61-47914 has a structure in which a mask and a wafer is disposed inside the optical system, and it is very difficult to apply it to a projection optical system of an exposure apparatus.
In the prior art catoptric system structures disclosed in U.S Patent No. 5,815,310, Japanese Patent Application Laid-Open No. 9-211322 and WO99/57606, though the optical system is disposed between a mask and a wafer, the size of one or more reflecting mirrors is large and the effective diameter thereof is substantially larger than the effective diameter of the mask. Consequently, it is difficult to produce the optical systems.
Furthermore, in the prior art catoptric system structures disclosed in U.S Patent No. 5,686,728 and Japanese Patent Application Laid-Open No. 10-90602, though the optical system is disposed between a mask and a wafer, the size of one or more reflecting mirrors is large and the effective diameter thereof is substantially larger than the effective diameter of the mask. Consequently, it is difficult to produce the optical systems. In addition, in those structures, since two convex reflecting mirrors are used on the wafer side, the angle of rays with respect to the optical axis becomes large and therefore the size of the reflecting mirrors becomes large.

<u>DISCLOSURE OF THE INVENTION</u>

The present invention has been made in view of the above-described problems. An object of the present invention is to provide a catoptric projection optical system in which aberrations are favorably corrected while avoiding upsizing of reflecting mirrors. Another object is to use the projection optical system according to the present invention in an exposure apparatus to realize an exposure apparatus in which a high resolution is ensured when for example X-rays are used as exposure light.
In order to solve the above-described problems, according to the first invention, there is provided a projection optical system including six reflecting mirrors for projecting a reduced image of a first surface on a second surface, comprising:

a first catoptric imaging optical system to form an intermediate image of the first surface; and
a second catoptric imaging optical system to form an image of the intermediate image on the second surface;

wherein the first catoptric imaging optical system includes a pair of convex reflecting mirrors arranged to be opposed to each other.

According to a preferred form of the first invention, it is preferable that the first catoptric imaging optical system comprise a first concave reflecting mirror for reflecting light from the first surface, a second convex reflecting mirror for reflecting light reflected from the first concave reflecting mirror, a third convex reflecting mirror for reflecting light reflected from the second convex reflecting mirror, and a fourth concave reflecting mirror for reflecting light reflected from the third convex reflecting mirror. In this case it is preferable that an aperture stop be provided in the optical path from the second convex reflecting mirror to the third convex reflecting mirror.

According to a preferred form of the first invention, it is preferable that the largest effective radius among the six reflecting mirrors is smaller than the maximum object height at the first surface. In addition it is preferable that the projection optical system be an optical system that is telecentric on the second surface side. Furthermore, it is preferable that the second catoptric imaging optical system comprise a fifth convex reflecting mirror for reflecting light from the intermediate image and a sixth concave reflecting mirror for reflecting light reflected from the fifth convex reflecting mirror.

According to a preferred form of the first invention, letting rmax be a largest effective radius among the six reflecting mirrors and letting H0 be a maximum object height at the first surface, the following condition is satisfied:

$$(rmax-H0)/H0 < 0.3$$

According to the second invention, there is provided a projection optical system provided with at least six reflecting mirrors for forming a reduced image of a first surface on a second surface by two times of imaging, wherein the largest effective radius among the six reflecting mirrors is smaller than the maximum object height at the first surface.

According to the third invention, there is provided an exposure apparatus comprising an illumination system for illuminating a mask set on the first surface and a projection optical system according to the first or second invention for projecting and exposing a pattern of a mask onto a photosensitive substrate set on the second surface.

According to a preferred form of the third invention, the illumination system comprises a light source for supplying X-ray as exposure light and the exposure apparatus projecting and exposing the pattern of the mask onto the photosensitive substrate while moving the mask and the photosensitive substrate relative to the projection optical system.

BRIEF DESCRIPTION OF THE DRAWINGS

Fig. 1 schematically shows the structure of an exposure apparatus according to an embodiment of the present invention.
Fig. 2 illustrates a positional relationship of an arcuate exposure area (i.e. an effective exposure area) formed on a wafer and an optical axis.
Fig. 3 is a diagram showing the configuration of a projection optical system according to a first example of the present embodiment.
Fig. 4 shows comas appearing in the projection optical system of the first example.
Fig. 5 is a diagram showing the configuration of a projection optical system according to a second example of the present embodiment.
Fig. 6 shows comas appearing in the projection optical system of the second example.
Fig. 7 is a flow chart of a process for producing semiconductor devices as micro devices.

THE PREFERRED EMBODIMENTS OF THE INVENTION

In the projection optical system according to the present invention, light from a first surface (i.e. an object surface) forms an intermediate image of the first surface via a first catoptric imaging optical system. Then, light from the intermediate image of the first surface formed by the first catoptric imaging optical system forms an image of the intermediate image (i.e. an reduced image of the first surface) on a second surface (i.e. an image surface) via a second catoptric imaging optical system. The first catoptric imaging optical system includes a pair of convex reflecting mirrors arranged to be opposed to each other.

According to a specific embodiment of the invention, the first catoptric imaging optical system is composed of a first concave reflecting mirror for reflecting light from the first surface, a second convex reflecting mirror for reflecting light reflected from the first concave reflecting mirror, a third convex reflecting mirror for reflecting light reflected from the second convex reflecting mirror, and a fourth concave reflecting mirror for reflecting light reflected from the third convex reflecting mirror. In addition, the second catoptric imaging optical system is composed of a fifth convex reflecting mirror for reflecting light from the intermediate image and a sixth concave reflecting mirror for reflecting light reflected from the fifth convex reflecting mirror.

In the aforementioned conventional catoptric optical systems, a concave reflecting mirror, a convex reflecting mirror and a concave reflecting mirror arranged in the mentioned order along the light traveling direction constitute a catoptric imaging optical system. In this catoptric imaging optical system composed of three reflecting mirrors of the concave-convex-concave arrangement (that is, the Offner type catoptric imaging optical system), the power of the central convex reflecting mirror tends to become high in accordance with the power of the concave reflecting mirror pair. This can cause a problem that aberrations are likely to be generated.

In view of the above, in the present invention, a pair of convex reflecting mirrors arranged to be opposed to each other are provided in the first catoptric imaging optical system. More specifically, in the first catoptric imaging optical system, a four mirror structure of a concave-convex-convex-concave arrangement is adopted, wherein a pair of convex reflecting mirrors are disposed between a pair of concave reflecting mirrors. With the replacement of a convex reflecting mirror disposed as the center mirror in the Offner type system by two convex reflecting mirrors, the power that has been required for the single convex reflecting mirror in the center is shared among the two convex reflecting mirror. Thus, generation of meridional coma and sagittal coma, which are apt to occur in a convex reflecting mirror, can be favorably reduced.

In that arrangement, light fluxes will be reflected by the two convex reflecting mirrors opposed to each other at large angles relative to the optical axis. Nevertheless, in the present invention, since two opposed convex reflecting mirrors are provided only in the first catoptric imaging optical system, which is the imaging system on the first surface side (i.e. the enlarging side), and light fluxes are made incident on the concave reflecting mirror at reduced angles relative to the optical axis by appropriately setting the power and position of the convex reflecting mirrors, abaxial aberrations can be favorably reduced.

Furthermore, since the two convex reflecting mirrors are disposed, in the first catoptric imaging optical system serving as an imaging optical system on the first surface side, at a position at which the cross section of the light flux is small, rays can be effectively separated, and therefore upsizing of the reflecting mirrors can be avoided. Consequently, manufacturing and adjustment of the optical system is made easy. In addition, with the use of the four mirror structure of the concave-convex-convex-concave arrangement in the first catoptric imaging optical system, an aperture stop that does not block effective light fluxes can be provided between the pair of convex reflecting mirrors.

Still further, the present invention adopts an arrangement in which a reduced image of the first surface is formed on the second surface through two times of imaging in which imaging is performed in two stages, distortion can be corrected effectively. It is preferable that the projection optical system according to the present invention be designed as an optical system that is telecentric on the second surface side.

In addition, with the use of the projection optical system according to the present invention in an exposure apparatus, X-rays can be used as exposure light. In that case, a mask and a photosensitive substrate are moved in a relative manner so that a pattern on the mask is projected and exposed onto the photosensitive substrate. Consequently, high precision micro devices can be manufactured under favorable exposure conditions using a scanning type exposure apparatus having a high resolution.

In the following, an embodiment of the present invention will be described with reference to the accompanying drawings.

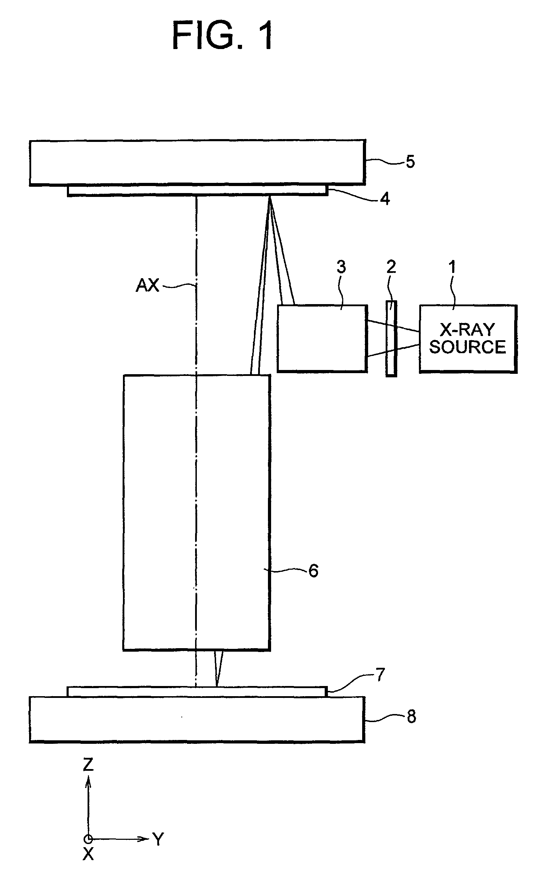

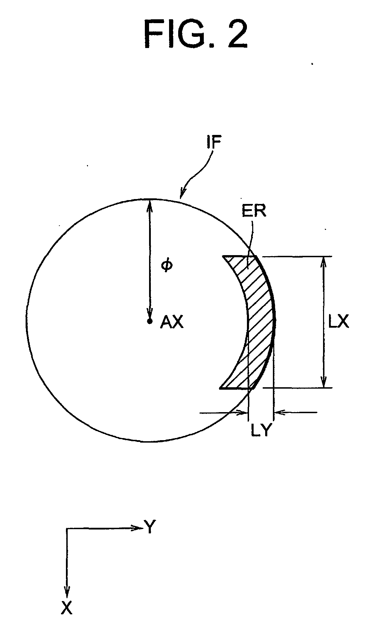

Fig. 1 schematically shows an exposure apparatus according to an embodiment of the present invention. Fig. 2 shows a positional relationship between the optical axis and an arcuate exposure area (i.e. an effective exposure area) formed on a wafer. In Fig. 1, Z-axis is set in the normal line direction of the wafer serving as a photosensitive substrate, Y-axis is set in the direction parallel to the plane of the drawing sheet of Fig. 1, and X-axis is set in the plane of the wafer and in the direction perpendicular to the plane of the drawing sheet of Fig. 1.

The exposure apparatus shown in Fig. 1 is provided with, for example, a laser plasma X-ray source 1 as a light source for supplying exposure light. Light emitted from the X-ray source 1 is made incident on an illumination optical system 3 via a frequency selecting filter 2. The wavelength selecting filter 2 selectively transmits X-ray of a specific wavelength (13.4nm) in the light supplied from the X-ray source 1 and blocks the light having other wavelengths.

The X-ray transmitted through the wavelength selecting filter 2 illuminates a reflection type mask 4, which has a pattern to be transferred formed thereon, via an illumination optical system 3 composed of a plurality of reflecting mirrors. The mask 4 is held by a mask stage 5 that can move in the Y direction so that the mask 4 is disposed in such a way that its pattern surface extends parallel to the X-Y plane. Movement of the mask stage 5 is adapted to be measured by a laser interferometer, which is not shown in the drawings. Thus, an arcuate illumination area that is symmetrical with respect to the Y-axis is formed on the mask 4.

Light from the pattern of the illuminated mask 4 forms an image of the mask pattern on the wafer 7 serving as a photosensitive substrate via a catoptric projection optical system 6. Thus, an arcuate exposure area that is symmetrical with respect to the Y-axis is formed on the wafer 7 as shown in Fig. 2. Referring to Fig. 2, an effective exposure area ER of an arcuate shape with a length in the X direction of LX and a length in the Y direction of LY is set in a circular area (i.e. an image circle) with a radius $\Phi$. The effective exposure area ER is formed along the outer circumference of the image circle IF.

The wafer 7 is held by a wafer stage 8 that can move in the Y and Y directions so that the wafer 7 is disposed in such a way that its exposure surface extends parallel to the X-Y plane. Movement of the wafer stage 8 is adapted to be measured by a laser interferometer, which is not shown in the drawings, in a similar manner as the mask stage 5. With the above-described structure, scanning exposure is performed while moving the mask 4 and the wafer 7 in the Y direction relative to the projection optical system 6, so that the pattern of the mask 4 is transferred onto one exposure area of the wafer 7.

In the case that the projection magnification (or transfer magnification) of the projection optical system 6 is 1/5 (or 1/4), the movement speed of the wafer stage 8 is set to 1/5 (or 1/4) times the movement speed of the mask stage 5 so that synchronized scanning is performed. The scanning exposure is repeatedly performed while shifting the wafer stage 8 in the X and Y directions respectively, so that the pattern of the mask 4 is sequentially transferred onto each of the exposure areas on the wafer 7. In the following, the specific structure of the projection optical system 6 will be described with reference to first and second examples.

In each of the examples, the projection optical system 6 is composed of a first catoptric imaging optical system G1 for forming an intermediate image of the pattern of the mask 4 and a second catoptric imaging optical system G2 for forming an image of the intermediate image of the mask pattern (i.e. a secondary image of the pattern of the mask 4) on the wafer 7. The first catoptric imaging optical system G1 is composed of four reflecting mirrors CM1 to CM4 and the second catoptric imaging optical system G2 is composed of two reflecting mirrors CM 5 and CM6.

In each of the examples, all of the reflecting mirrors R1 - R6 are designed as aspherical surfaces. In addition, in each of the examples, an aperture stop AS is arranged in the optical path from the second convex reflecting mirror CM2 to the third convex reflecting mirror CM3. Furthermore, in each of the examples, the projection optical system 6 is designed as an optical system that is telecentric on the wafer side (i.e. on the image side).

In those examples, the aspherical surfaces are expressed by the following mathematical expression (b):

$$Z = (y^2/r)/[1+\{1-(1+\kappa)\cdot y^2/r^2\}^{1/2}]$$
$$+C4\cdot y^4+C6\cdot y^6+C8\cdot y^8+C10\cdot y^{10} \qquad \text{(b)}$$

where, y represents the height measured in the direction perpendicular to the optical axis, z represents the distance (or sag amount) along the optical axis from the tangential plane at the vertex of the aspherical surface to the point on the aspherical surface at height y, r represents the radius of curvature at the vertex, $\kappa$ is the constant of the cone, and Cn represents the aspherical surface coefficient of n-th order.

[First Example]

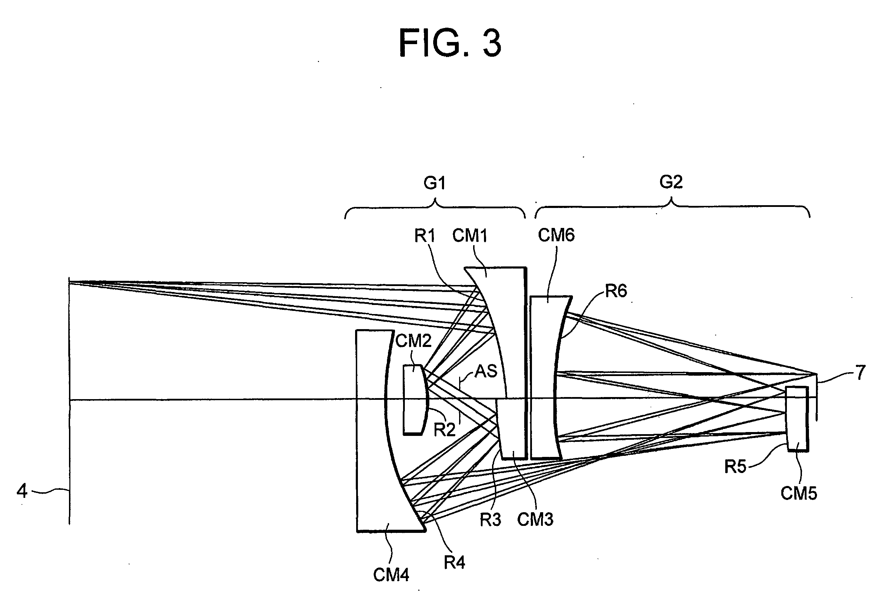

Fig. 3 is a diagram showing the configuration of a projection optical system according to the first example of the present embodiment. Referring to Fig. 3, in the projection optical system according to the first example, light from the mask 4 forms an intermediate image of the mask pattern after sequentially reflected by the reflection surface R1 of the first concave reflecting mirror CM1, the reflection surface R2 of the second convex reflecting mirror CM2, the reflection surface R3 of the third convex reflecting mirror CM3 and the reflection surface R4 of the fourth concave reflecting mirror CM4. Light from the intermediate image of the mask pattern formed via the first catoptric imaging optical system G1 forms a reduced image (as a secondary image) of the mask pattern on the wafer 7 after sequentially reflected by the reflection surface R5 of the fifth convex reflecting mirror CM5 and the reflection surface R6 of the sixth concave reflecting mirror CM6.

Various values associated with the projection optical system according to the first example will be listed in the following Table 1. In Table 1, $\lambda$ represents the wavelength of the exposure light, $\beta$ represents the projection magnification, NA represents the numerical aperture on the image side (i.e. on the wafer side), H0 represents the maximum object height on the mask 4, $\Phi$ represents the radius of the image circle IF on the wafer 7, LX represents the dimension of the effective exposure area ER along the X direction, and LY represents the dimension of the effective exposure area ER along the Y direction.

The surface numbers refer to the reflection surfaces numbered in the order from the mask surface as the object surface to the wafer surface as the image surface along the direction of traveling rays, r represents the radius (mm) of curvature at the vertex of each reflection surface and d represents the on-axis distance or the surface distance (mm) between the reflection surfaces. The signs (positive and negative) of the surface distances d shall change every time light is reflected. In addition, the radius of curvature of a surface that is convex toward the mask side is expressed by a positive value and the radius of curvature of a surface that is concave toward the mask side is expressed by a negative value, irrespective of the direction of incidence of rays on those surfaces. The above-described notations on Table 1 also apply to Table 2 that will appear later.

(Table 1)
(Basic Specifications)

$\lambda$ = 13.4nm

$\beta$ = 1/5

NA = 0.25

H0 = 127.5mm

$\Phi$ = 25.5mm

LX = 22mm

LY = 1mm

| (Specifications of Optical Members) | | | |
|---|---|---|---|
| Surface Number | r | d | |
| | (mask surface) | 447.092751 | |
| 1 | -240.93572 | -82.186820 | (1st ref. mirror CM1) |
| 2 | -144.29014 | 31.973126 | (2nd ref. mirror CM2) |
| 3 | $\infty$ | 40.265911 | (aperture stop AS) |
| 4 | 362.83518 | -116.873686 | (3rd ref. mirror CM3) |
| 5 | 234.62624 | 407.806079 | (4th ref. mirror CM4) |
| 6 | 485.49007 | -230.984610 | (5th ref. mirror CM5) |
| 7 | 294.69835 | 260.984610 | (6th ref. mirror CM6) |
| | (wafer surface) | | |

| (Aspherical Surface Data) | |
|---|---|
| 1st surface | |
| $\kappa$ = 0.000000 C4 = 0.423873$\times$10$^{-8}$ C8 = 0.649601$\times$10$^{-18}$ | C6 = 0.280205$\times$10$^{-13}$ C10 = 0.128292$\times$10$^{-22}$ |
| 2nd surface | |
| $\kappa$ = 0.000000 C4 = 0.483249$\times$10$^{-7}$ C8 = 0.465232$\times$10$^{-14}$ | C6 = -0.151325$\times$10$^{-10}$ C10 = -0.950238$\times$10$^{-18}$ |
| 4th surface | |
| $\kappa$ = 0.000000 C4 = -0.144826$\times$10$^{-7}$ C8 = -0.706701$\times$10$^{-16}$ | C6 = 0.462111$\times$10$^{-11}$ 10 = -0.842010$\times$10$^{-19}$ |

(continued)

| (Aspherical Surface Data) | |
|---|---|
| 5th surface | |
| $\kappa$ = 0.000000<br>C4 = 0.649254×10$^{-9}$<br>C8 = -0.165968×10$^{-18}$ | C6 = 0.385603×10$^{-13}$<br>C10 = 0.492086×10$^{-22}$ |
| 6th surface | |
| $\kappa$ = 36.865234<br>C4 = -0.763771×10$^{-8}$<br>C8 = -0.741722×10$^{-16}$ | C6 = -0.274219×10$^{-11}$<br>C10 = -0.103179×10$^{-18}$ |
| 7th surface | |
| $\kappa$ = -0.111369<br>C4 = 0.923055×10$^{-9}$<br>C8 = 0.129437×10$^{-18}$ | C6 = 0.122655×10$^{-13}$<br>C10 = 0.163421×10$^{-23}$ |

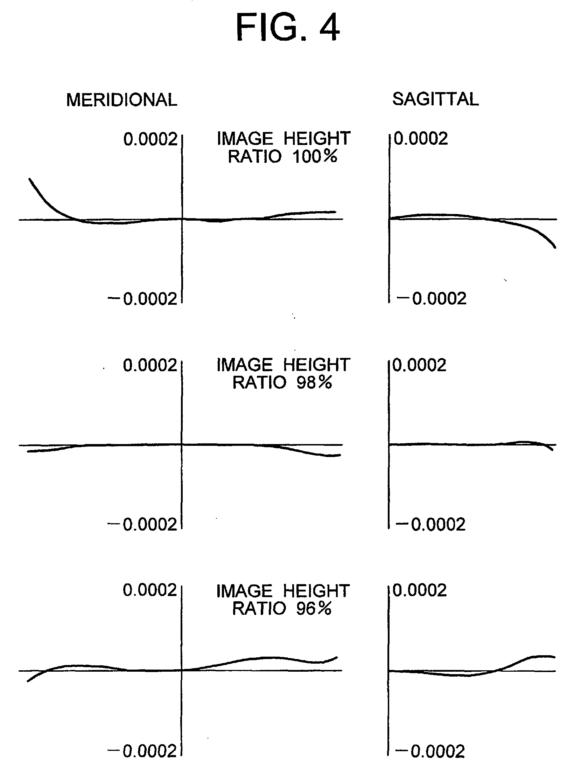

Fig. 4 shows comas in connection with the projection optical system according to the first example. In Fig. 4, there is illustrated meridional and sagittal comas at image heights of 100%, 98% and 96%. As will be apparent from the curves in Fig. 4, comas are favorably corrected in the first example in the area corresponding to the effective exposure area ER. In addition, it has been confirmed that other various aberrations than comas such as spherical aberration and distortion are favorably corrected, though graphical illustrations thereof have been omitted. In the projection optical system according to the present invention, since the four mirror structure of the concave-convex-convex-concave arrangement is adopted in the first catoptric imaging optical system, required power is shared among the two convex reflecting mirrors. Thus, generation of meridional coma and sagittal coma, which are apt to occur in convex reflecting mirrors, can be favorably reduced.

[Second Example]

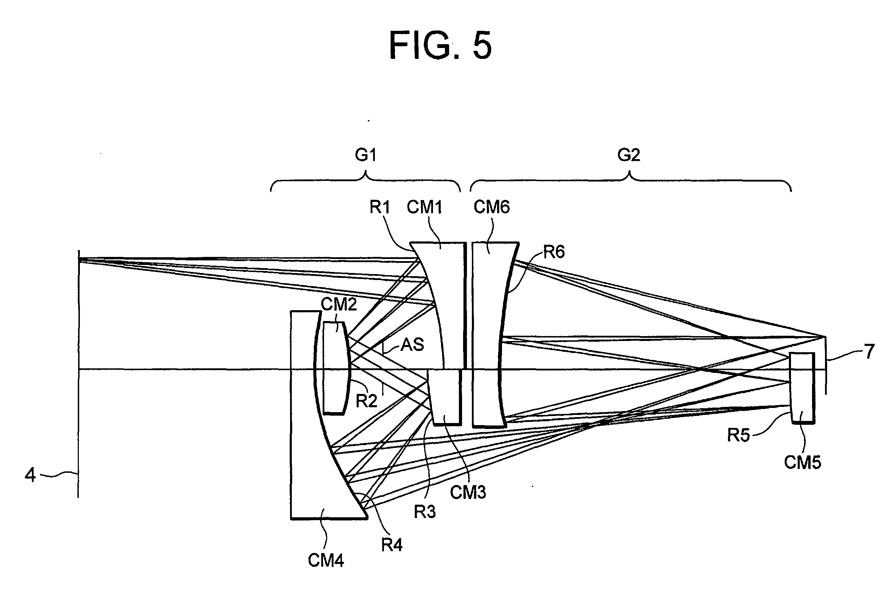

Fig. 5 is a diagram showing the configuration of a projection optical system according to the second example. Referring to Fig. 5, in the projection optical system according to the second example, light from the mask 4 forms an intermediate image of the mask pattern after sequentially reflected by the reflection surface R1 of the first concave reflecting mirror CM1, the reflection surface R2 of the second convex reflecting mirror CM2, the reflection surface R3 of the third convex reflecting mirror CM3 and the reflection surface R4 of the fourth concave reflecting mirror CM4. Light from the intermediate image of the mask pattern formed via the first catoptric imaging optical system G1 forms a reduced image (as a secondary image) of the mask pattern on the wafer 7 after sequentially reflected by the reflection surface R5 of the fifth convex reflecting mirror CM5 and the reflection surface R6 of the sixth concave reflecting mirror CM6. Various values associated with the projection optical system according to the second example will be listed in the following Table 2.

<div align="center">

(Table 2)<br>
(Basic Specifications)<br>
$\lambda$ = 13.4nm<br>
$\beta$ = 1/4<br>
NA = 0.25<br>
H0 = 102.0mm<br>
$\Phi$ = 25.5mm<br>
LX = 22mm<br>
LY = 1mm

</div>

| (Specifications of Optical Members) | | | |
|---|---|---|---|
| Surface Number | r | d | |
| | (mask surface) | 322.082133 | |
| 1 | -249.77916 | -83.783880 | (1st ref. mirror CM1) |
| 2 | -198.73080 | 28.357610 | (2nd ref. mirror CM2) |
| 3 | ∞ | 40.265911 | (aperture stop AS) |
| 4 | 199.14844 | -101.238567 | (3rd ref. mirror CM3) |
| 5 | 211.03437 | 419.406463 | (4th ref. mirror CM4) |
| 6 | 561.34334 | -253.007537 | (5th ref. mirror CM5) |
| 7 | 317.63701 | 283.007536 | (6th ref. mirror CM6) |
| | (wafer surface) | | |

| (Aspherical Surface Data) | |
|---|---|
| 1st surface | |
| $\kappa = 0.000000$ <br> $C4 = 0.109861\times10^{-8}$ <br> $C8 = 0.574952\times10^{-18}$ | $C6 = -0.338066\times10^{-13}$ <br> $C10 = -0.148732\times10^{-22}$ |
| 2nd surface | |
| $\kappa = 0.000000$ <br> $C4 = -0.330798\times10^{-7}$ <br> $C8 = 0.504628\times10^{-14}$ | $C6 = -0.145227\times10^{-10}$ <br> $C10 = -0.140464\times10^{-17}$ |
| 4th surface | |
| $\kappa = 0.000000$ <br> $C4 = -0.663628\times10^{-7}$ <br> $C8 = -0.678995\times10^{-15}$ | $C6 = 0.824203\times10^{-11}$ <br> $10 = -0.376375\times10^{-19}$ |
| 5th surface | |
| $\kappa = 0.000000$ <br> $C4 = -0.510121\times10^{-9}$ <br> $C8 = -0.559626\times10^{-19}$ | $C6 = 0.255721\times10^{-14}$ <br> $C10 = 0.155693\times10^{-22}$ |
| 6th surface | |
| $\kappa = 36.865234$ <br> $C4 = 0.375867\times10^{-8}$ <br> $C8 = 0.103513\times10^{-15}$ | $C6 = -0.121592\times10^{-11}$ <br> $C10 = -0.525952\times10^{-19}$ |
| 7th surface | |
| $\kappa = -0.111369$ <br> $C4 = 0.720534\times10^{-9}$ <br> $C8 = 0.755276\times10^{-19}$ | $C6 = 0.831849\times10^{-14}$ <br> $C10 = 0.587150\times10^{-24}$ |

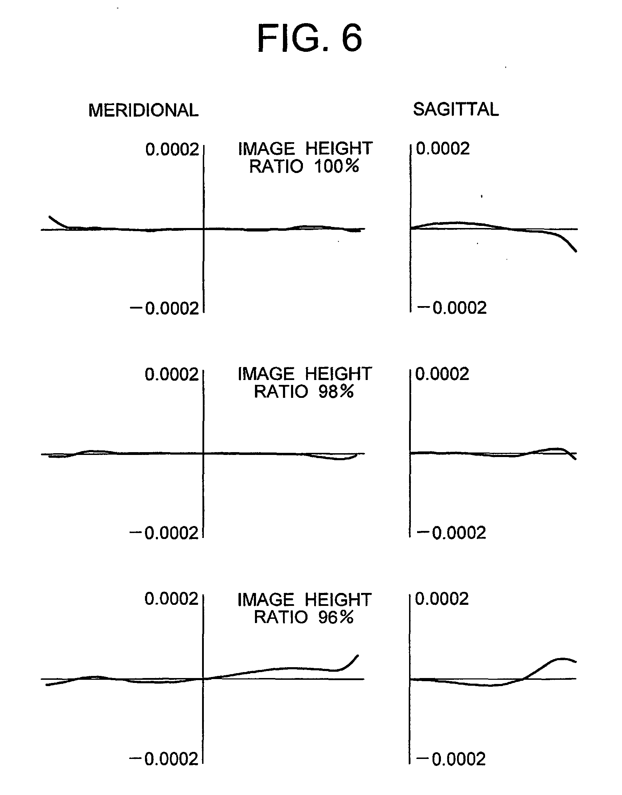

Fig. 6 shows comas in connection with the projection optical system according to the second example. In Fig. 6, there is illustrated meridional and sagittal comas at image heights of 100%, 98% and 96%. As will be apparent from the curves in Fig. 6, comas are favorably corrected in the second example in the area corresponding to the effective exposure area ER as is the case with the first example. In addition, it has been confirmed that other various aberrations than comas such as spherical aberration and distortion are favorably corrected, though graphical illustrations thereof have been omitted.

As per the above, in each of the above-described examples, it is possible to ensure a numerical aperture on the image side as large as 0.25 for laser plasma X-ray having a wavelength of 13.4nm and to ensure an arcuate effective exposure area of 22mm×1mm on the wafer 7 while various aberrations are favorably corrected. Therefore, it is possible to transfer a mask pattern onto each exposure area of 22mm×33mm at a high resolution equal to or less than 0.1μm by scanning exposure.

In the first example, the effective radius of the fourth concave reflecting mirror CM4, which is the largest effective radius (rmax) among the reflecting mirrors, is 125mm. This largest radius is smaller than the maximum object height H0=127.5mm. On the other hand, in the second example also, the effective radius of the fourth concave reflecting mirror CM4, which is the largest effective radius (rmax) among the reflecting mirrors, is 125mm. Though this largest radius is larger than the maximum object height H0=102.0, the value of (rmax-H0)/H0 is 0.25, which is a sufficiently small value. As per the above, in the above-described examples, upsizing of the reflection mirrors is avoided and the optical system can be kept compact.

In the first example, the distance between the object plane (i.e. the mask surface) and the image plane (i.e. the wafer surface) is 758mm, and in the second example, the distance between the object plane and the image plane is 655mm. As per the above, the distance between the object plane and the image plane is kept small. Therefore, it is possible to realize a high performance and high precision optical system while keeping the apparatus compact.

In the above-described examples, the angle of the rays incident on the mask 4 and the rays reflected by the mask 4 relative to the optical axis AX is kept relatively small. By virtue of that, the systems are not susceptible to shadows involved by reflection in spite of that a reflection type mask 4 is used. Consequently, performance of the system of those examples is hard to be deteriorated. In addition, the systems of the above-described examples are advantageous in that large magnification variations are unlikely to occur even if there is a slight error in the position of the mask 4. However, if they are designed to be completely telecentric, interference of incident light and emergent light occurs. Therefore, it is necessary to leave inclination to some extent. In the present invention the system is arranged in such a way that the aforementioned angle is made minimum while avoiding interference.

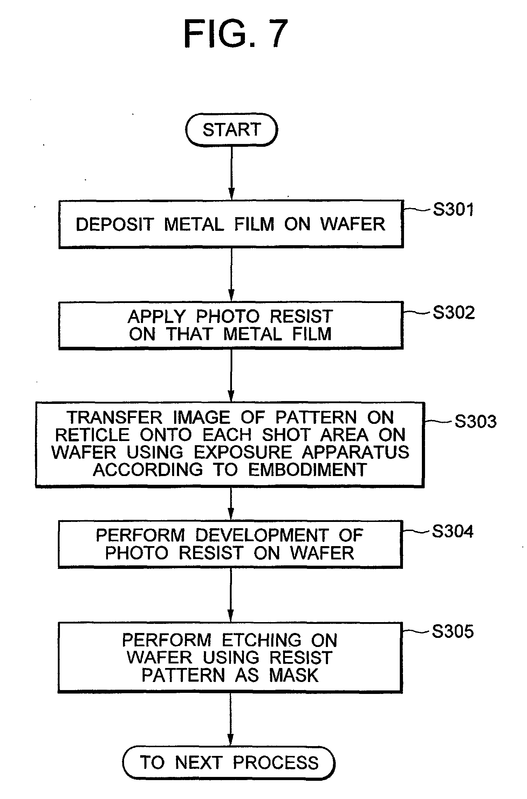

With the exposure apparatus according to the above-described embodiment, it is possible to manufacture micro devices (such as semiconductor devices, imaging devices, liquid crystal display devices or thin film magnetic heads etc.) by illuminating a mask with an illumination system (an illumination process) and exposing a pattern to be transferred formed on a mask onto a photosensitive substrate using a projection optical system. In the following, a description will be made, with reference to Fig. 7, of an example of a process for producing a micro device in the form of a semiconductor device by forming a prescribed circuit pattern on a photosensitive substrate in the form of a wafer or the like using the exposure apparatus according this embodiment.

Firstly, in step 301 in Fig. 7, metal films are deposited on one lot of wafers. In step 302, photo resist is applied on the metal films on the one lot of wafers. Then in step 303, the exposure apparatus according to this embodiment is used to transfer an image of a pattern on a mask (or a reticle) onto each shot area of the one lot of wafers sequentially by exposure via the projection optical system of the apparatus.

After that, in step 304, the photo resist on the one lot of wafers is developed. Then in step 305, etching is performed on the one lot of wafers using the resist patterns as masks, so that a circuit pattern corresponding to the pattern on the mask is formed on each of the shot areas of each wafer. After that, a process(es) for forming a circuit pattern(s) of the upper layer(s) and other processes are performed. Thus devices such as semiconductor devices are produced. According to the above-described process of manufacturing semiconductor devices, it is possible to produce semiconductor devices having extremely micro patterns with a high throughput.

While in the above-described embodiment a laser plasma X-ray source is used as a light source for supplying X-rays, the light source is not limited to that but for example, synchrotron orbital radiation (SOR) light may also be used as X-ray.

Furthermore, while in the above-described embodiment, the present invention is applied to an exposure apparatus provided with a light source that supplies X-rays, the application of the invention is not limited to that type of apparatus. The present invention can also be applied to an exposure apparatus provided with a light source that supplies light of a wavelength other than X-rays.

Still further, while in the above-described embodiment, the present invention is applied to a projection optical system in an exposure apparatus, the application of the present invention is not limited to that but it can be applied to other general projection optical systems.

As has been described in the forgoing, in the projection optical system according to the present invention, two convex reflecting mirrors are disposed, in the first catoptric imaging optical system serving as an imaging optical system on the first surface side, at a position at which the cross section of the light flux is small. Consequently, rays can be effectively separated and upsizing of the reflecting mirrors can be avoided. Therefore, according to the invention it is possible to realize a catoptric projection optical system in which aberrations are favorably corrected while avoiding upsizing of reflecting mirrors.

In addition, with the application of the projection optical system according to the present invention, it is possible to use X-rays as exposure light. In that case, a pattern of a mask is projected and exposed onto a photosensitive substrate while the mask and the photosensitive substrate are moved relative to the projection optical system. Consequently, it is possible to manufacture high precision micro devices under favorable exposure conditions using a scanning type exposure apparatus having a high resolution.

**Claims**

1. A projection optical system having six reflecting mirrors for projecting a reduced image of a first surface on a second surface, comprising:

   a first catoptric imaging optical system to form an intermediate image of said first surface; and
   a second catoptric imaging optical system to form an image of said intermediate image on said second surface;

   wherein said first catoptric imaging optical system includes a pair of convex reflecting mirrors arranged to be opposed to each other.

2. A projection optical system according to claim 1, wherein said first catoptric imaging optical system comprises a first concave reflecting mirror for reflecting light from said first surface, a second convex reflecting mirror for reflecting light reflected from said first concave reflecting mirror, a third convex reflecting mirror for reflecting light reflected from said second convex reflecting mirror, and a fourth concave reflecting mirror for reflecting light reflected from said third convex reflecting mirror.

3. A projection optical system according to claim 2, wherein an aperture stop is provided in an optical path from said second convex reflecting mirror to said third convex reflecting mirror.

4. A projection optical system according to any one of claims 1 to 3, wherein a largest effective radius among said six reflecting mirrors is smaller than a maximum object height at said first surface.

5. A projection optical system according to any one of claims 1 to 3, wherein letting rmax be a largest effective radius among said six reflecting mirrors and letting H0 be a maximum object height at said first surface, the following condition is satisfied:

$$(rmax-H0)/H0 < 0.3$$

6. A projection optical system according to any one of claims 1 to 3, wherein said projection optical system is an optical system that is telecentric on said second surface side.

7. A projection optical system according to any one of claims 1 to 3, wherein said second catoptric imaging optical system comprises a fifth convex reflecting mirror for reflecting light from said intermediate image and a sixth concave reflecting mirror for reflecting light reflected from said fifth convex reflecting mirror.

8. A projection optical system provided with at least six reflecting mirrors for forming a reduced image of a first surface on a second surface by two times of imaging, wherein a largest effective radius among said six reflecting mirrors is smaller than a maximum object height at said first surface.

9. A projection optical system provided with at least six reflecting mirrors for forming a reduced image of a first surface on a second surface by two times of imaging, wherein letting rmax be a largest effective radius among said six reflecting mirrors and letting H0 be a maximum object height at said first surface, the following condition is satisfied:

$$(rmax-H0)/H0 < 0.3$$

10. An exposure apparatus comprising an illumination system for illuminating a mask set on said first surface and a projection optical system according to any one of claims 1, 2, 3, 8 and 9 for projecting and exposing a pattern of a mask onto a photosensitive substrate set on said second surface.

11. An exposure apparatus according to claim 10 wherein said illumination system comprises a light source for supplying X-ray as exposure light and said exposure apparatus projecting and exposing said pattern of the mask onto said photosensitive substrate while moving said mask and said photosensitive substrate relative to said projection optical system.

# FIG. 1

# FIG. 2

# FIG. 3

EP 1 413 909 A1

# FIG. 4

MERIDIONAL                                    SAGITTAL

0.0002        IMAGE HEIGHT          0.0002
              RATIO 100%

−0.0002                            −0.0002


0.0002        IMAGE HEIGHT          0.0002
              RATIO 98%

−0.0002                            −0.0002


0.0002        IMAGE HEIGHT          0.0002
              RATIO 96%

−0.0002                            −0.0002

# FIG. 5

# FIG. 6

MERIDIONAL

SAGITTAL

IMAGE HEIGHT RATIO 100%

IMAGE HEIGHT RATIO 98%

IMAGE HEIGHT RATIO 96%

# FIG. 7

```
        ┌─────────┐
        │  START  │
        └─────────┘
             │
             ▼
┌──────────────────────────────┐      ~S301
│  DEPOSIT METAL FILM ON WAFER  │
└──────────────────────────────┘
             │
             ▼
┌──────────────────────────────┐      ~S302
│     APPLY PHOTO RESIST        │
│      ON THAT METAL FILM       │
└──────────────────────────────┘
             │
             ▼
┌──────────────────────────────┐      ~S303
│  TRANSFER IMAGE OF PATTERN ON │
│  RETICLE ONTO EACH SHOT AREA ON│
│  WAFER USING EXPOSURE APPARATUS│
│    ACCORDING TO EMBODIMENT     │
└──────────────────────────────┘
             │
             ▼
┌──────────────────────────────┐      ~S304
│    PERFORM DEVELOPMENT OF     │
│     PHOTO RESIST ON WAFER     │
└──────────────────────────────┘
             │
             ▼
┌──────────────────────────────┐      ~S305
│      PERFORM ETCHING ON       │
│      WAFER USING RESIST       │
│       PATTERN AS MASK         │
└──────────────────────────────┘
             │
             ▼
     ┌─────────────────┐
     │  TO NEXT PROCESS │
     └─────────────────┘
```

## INTERNATIONAL SEARCH REPORT

| International application No. |
|---|
| PCT/JP02/05532 |

**A. CLASSIFICATION OF SUBJECT MATTER**
   Int.Cl$^7$ G02B17/06, H01L21/027

According to International Patent Classification (IPC) or to both national classification and IPC

**B. FIELDS SEARCHED**

Minimum documentation searched (classification system followed by classification symbols)
   Int.Cl$^7$ G02B17/06, H01L21/027

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2002 |
| Kokai Jitsuyo Shinan Koho | 1971–2002 | Jitsuyo Shinan Toroku Koho | 1996–2002 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2000-235144 A (Carl-Zeiss-Stiftung trading as Carl Zeiss), 29 August, 2000 (29.08.00), Full text; all drawings & EP 1035445 A2 | 1-11 |
| Y | US 6109756 A (Nikon Corp.), 21 September, 1999 (21.09.99), Full text; all drawings & JP 2000-98227 A | 1-11 |

☐ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 16 July, 2002 (16.07.02) | 30 July, 2002 (30.07.02) |

| Name and mailing address of the ISA/ | Authorized officer |
|---|---|
| Japanese Patent Office | |
| Facsimile No. | Telephone No. |

Form PCT/ISA/210 (second sheet) (July 1998)